# FASCICULE DE BREVET EUROPEEN

(11) **EP 0 665 903 B1**
(45) Date de publication et mention de la délivrance du brevet: **24.04.1996**
(21) Numéro de dépôt: 93920922.7
(22) Date de dépôt: 23.09.1993
(51) Int. Cl.: C23C 16/50, C23C 16/44

(54) **APPAREIL DE DEPOT CHIMIQUE EN PHASE VAPEUR ACTIVE PAR UN PLASMA MICRO-ONDES**
Vorrichtung für Mikrowellen - Plasma - CVD
APPARATUS FOR CHEMICAL VAPOUR PHASE DEPOSITION ACTIVATED BY A MICROWAVE PLASMA

(30) Priorité: 24.09.1992 FR 9211391
(43) Date de publication de la demande: 09.08.1995
(73) Titulaire: OFFICE NATIONAL D'ETUDES ET DE RECHERCHES AEROSPATIALES, F-92322 Chatillon sous Bagneux (FR)
(72) Inventeur: SEIBERRAS, Ghislaine, F-92220 Fontenay-aux-Roses (FR); INDRIGO, Claude, F-94700 Maisons-Alfort (FR); MEVREL, Rémy, F-92350 Le Plessis-Robinson (FR); LEPRINCE, Philippe, F-91190 Gif-sur-Yvette (FR); BEJET, Michel, F-91940 Les Ulis (FR); LE PENNEC, Claude, F-94300 Vincennes (FR)
(74) Mandataire: Gorrée, Jean-Michel
(86) Numéro de dépôt international: FR9300926
(87) Numéro de publication internationale: WO9406950

(56) Documents cités:
- EP-A- 0 346 168
- EP-A- 0 366 924
- EP-A- 0 411 435
- US-A- 5 093 150
- JOURNAL OF THE CERAMIC SOCIETY OF JAPAN, INTERNATIONAL EDITION vol. 97, no. 10 , Octobre 1989 , TOKYO JP pages 105 - 110 XP114023 H. ITOH ET AL. 'PREPARATION OF ZRO2-MGO THIN FILMS BY OMCVD'
- PATENT ABSTRACTS OF JAPAN vol. 13, no. 388 (C-630)(3736) 28 Aoüt 1989 & JP,A,01 136 971 (FUJITSU LTD) 30 Mai 1989
- ED: G. LUCOVSKI 'AMERICAN VACUUM SOCIETY SERIES 9, HIGH TC SUPERCONDUCTING THIN FILMS: PROCESSING CHARACTERIZATION AND APPLICATIONS' 1990 , AMERICAN INSTITUTE OF PHYSICS , NEW YORK, US

## Description

La présente invention concerne le domaine du dépôt chimique en phase vapeur avec assistance d'un plasma et, plus spécifiquement, elle concerne un appareil de dépôt chimique en phase vapeur activé par un plasma, comprenant, disposés les uns à la suite des autres :
- plusieurs moyens de transformation d'état de précurseurs respectifs de plusieurs matériaux de dépôt pour les faire passer chacun d'un état initial à l'état gazeux,
- plusieurs moyens pour charger des gaz vecteurs en précurseurs gazeux respectifs, chaque gaz vecteur chargé en précurseur constituant un mélange gazeux prédéterminé,
- plusieurs moyens de transfert desdits mélanges gazeux prédéterminés vers un réacteur à plasma à excitation par micro-ondes comportant une enceinte de réaction, un générateur de micro-ondes, au moins un guide d'ondes interposé entre ledit générateur et l'enceinte assurant un couplage non résonant, et
- des moyens d'injection desdits mélanges gazeux prédéterminés dans l'enceinte de réaction.

Les appareils du type visé par l'invention sont destinés à former des dépôts de matériaux spéciaux, en particulier de céramiques, sur des substrats. Il est notamment possible de réaliser ainsi des barrières thermiques qui, étant déposées sur un revêtement protecteur approprié (par exemple en matériau MCrAlY), permettent de constituer des aubes de turbine thermiquement bien protégées: la température de fonctionnement des parties métalliques reste en deçà de la limite autorisée par le matériau de base et le revêtement protecteur tandis que la température des gaz à l'entrée de la turbine peut être notablement accrue (50 à 100°C), ce qui augmente d'autant le rendement de la turbine.

Actuellement, trois procédés d'obtention de barrières thermiques sont connus :
1°/ Le procédé de projection plasma est la technique la plus employée. Des grains de poudre de zircone partiellement stabilisée sont introduits dans un jet plasma ; ils y sont fondus et accélérés pour être projetés à grande vitesse sur un substrat placé en regard. Ils s'y solidifient rapidement et s'accrochent par adhérence mécanique aux aspérités préalablement créées à la surface des pièces, en général par sablage. Les revêtements obtenus ont une structure lamellaire, résultant de l'empilement de gouttelettes écrasées et solidifiées sous forme lenticulaire, solidification qui s'accompagne d'une microfissuration. Les dépôts les plus performants sont constitués d'une couche de zircone partiellement stabilisée par 6 à 8 % en poids d'yttrine déposée sur une sous-couche en alliage MCrAlY (M=Ni et/ou Co et/ou Fe), elle-même déposée par projection plasma sous atmosphère contrôlée. Habituellement les épaisseurs des couches céramiques ainsi obtenues sont de l'ordre de 300 µm. Cette technique conduit à des dépôts microfissurés constitués éventuellement de phases métastables avec des vitesses de dépôt très grandes de l'ordre de 100 µm/min. Il faut remarquer cependant qu'il s'agit d'un procédé directif et que des pièces de géométrie complexe sont difficiles, voire impossibles, à recouvrir. Par ailleurs, la rugosité de ces dépôts nécessite un traitement de finition pour rendre l'état de surface aérodynamiquement satisfaisant.
2°/ Le procédé d'évaporation sous bombardement électronique met en oeuvre un faisceau d'électrons émis par un filament chauffé. Accéléré par l'application d'un champ électrique, ce faisceau est dirigé vers le matériau à évaporer, en l'occurrence un barreau de zircone yttriée, au moyen d'un champ magnétique. Sous l'effet de ce bombardement électronique, les espèces sont évaporées et vont se condenser sur le substrat placé en regard de la source. Ce substrat éventuellement polarisé est préchauffé et/ou chauffé durant l'opération de dépôt. Les résultats obtenus par la mise en oeuvre de ce procédé présentent certains avantages :
   - la rugosité de la couche ainsi obtenue est mieux adaptée aux écoulements aérodynamiques,
   - la structure colonnaire du dépôt améliore le comportement thermomécanique,
   - la résistance à l'érosion est plus grande,
   - l'adhérence de la couche est meilleure.

Toutefois, il faut noter que la réalisation d'un revêtement de zircone yttriée effectué avec une vitesse de dépôt élevée (100 µm/h) nécessite une grande puissance électrique pour évaporer le barreau d'oxyde réfractaire. En outre, la mise en oeuvre de cette technique implique des investissements lourds et un savoir-faire important. De plus, ce procédé est lui aussi directionnel, c'est-à-dire que des pièces de forme complexe peuvent être difficiles, voire impossibles à revêtir.
3°/ Le procédé de pulvérisation cathodique radiofréquence permet de déposer des couches minces de zircone yttriée avec des vitesses de dépôt faibles de l'ordre de 1 µm/h. Dans ce procédé, un matériau porté à un potentiel négatif est soumis à un bombardement d'ions positifs. Les atomes de ce matériau, éjectés dans toutes les directions, vont se condenser notamment sur le substrat placé en regard pour y former le dépôt. Des systèmes ont été utilisés pour réaliser des dépôts de matériaux isolants (dépôts d'oxyde en particulier) avec des modifications éventuelles (magnétron, pulvérisation en atmosphère réactive, etc.) pour en accroître les vitesses de dépôt (jusqu'à quelques µm/h). Au moyen de cette technique, il est certainement plus facile de maîtriser la composition des dépôts comparativement au procédé d'évaporation sous bombardement électronique ; en revanche les vitesses de dépôt sont beaucoup plus faibles et, comme pour les deux procédés précédents, le dépôt se fait de manière directionnelle.

L'invention a essentiellement pour but de proposer un appareil de dépôt original, qui permette de combiner les avantages respectifs du dépôt chimique en phase vapeur et de l'assistance par un plasma, notamment : procédé non directif dépôt à structure contrôlée, abaissement de la température, augmentation de la vitesse de dépôt.

A ces fins, un appareil de dépôt chimique en phase vapeur activé par un plasma tel que défini au préambule ci-dessus se caractérise essentiellement, étant agencé conformément à l'invention, en ce que les moyens de transfert des mélanges gazeux prédéterminés respectifs sont indépendants les uns des autres et en ce que les moyens d'injection comportent une buse à profil externe tronconique dans laquelle débouchent les susdits moyens de transfert indépendants et qui est pourvue d'au moins un orifice d'injection, l'extrémité de ladite buse étant conformée en fonction de la configuration du jet de gaz ionisé désirée, cette buse étant équipée de moyens de chauffage et de calorifugeage du mélange gazeux prédéterminé.

Si le précurseur utilisé se présente à l'état solide ou liquide, on prévoit avantageusement que les moyens de transformation d'état du précurseur comprennent au moins une chambre équipée de moyens de réglage de température et/ou de pression pour la transformation en phase gazeuse de ce précurseur.

De façon souhaitable, le précurseur étant à l'état solide, les moyens pour charger un gaz vecteur en précurseur gazeux sont agencés pour que le gaz vecteur traverse le précurseur pulvérulent.

Le susdit gaz vecteur peut être soit neutre, soit réactif chimiquement avec le précurseur gazeux.

De préférence, les moyens de transfert du mélange gazeux prédéterminé comprenant au moins un tube chauffé et/ou calorifugé et au moins une vanne d'arrêt chauffée et/ou calorifugée. Lorsque plusieurs mélanges gazeux prédéterminés différents doivent être injectés dans l'enceinte, il peut être prévu une chambre de mélange dans laquelle débouchent tous les tubes de transfert respectifs des mélanges gazeux prédéterminés différents et qui est disposée en amont de l'orifice d'injection.

Pour ce qui est de l'injection proprement dite dans l'enceinte de réaction, la buse peut être agencée de toute manière appropriée aux résultats recherchés : elle peut être pourvue d'un unique orifice de sortie, ou bien être pourvue d'une multiplicité d'orifices de sortie définis par des moyens de subdivision (tels qu'une grille, un treillis, ou une plaque perforée) afin d'assurer une ionisation maximale du jet de gaz sous forme d'une colonne s'appuyant sur le porte-échantillon à revêtir disposé dans l'enceinte.

L'invention sera mieux comprise à la lecture de la description détaillée qui suit de certains modes de réalisation préférés donnés uniquement à titre d'exemples non limitatifs. Dans cette description, on se réfère aux dessins annexés sur lesquels :
- la figure 1 est une vue générale schématique des moyens essentiels mis en oeuvre dans l'appareil de dépôt en phase vapeur activé par un plasma conforme à l'invention ;
- la figure 2 est une vue en coupe transversale du porte-échantillons équipé des moyens de polarisation et de chauffage indépendants utilisé dans l'appareil de la fig. 1;
- la figure 3 est une vue en coupe transversale des moyens d'injection dans l'enceinte de réaction de l'appareil de la fig. 1 ; et
- les figures 4A, 4B et 4C montrent différentes géométries adoptables pour la buse d'injection des moyens de la fig. 3.

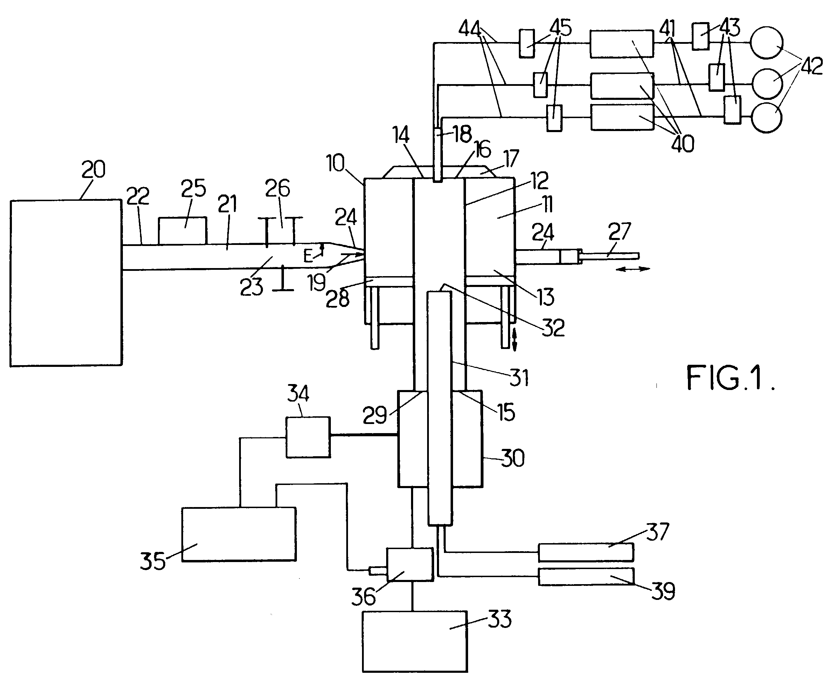

En se référant tout d'abord à la figure 1, l'appareil de dépôt chimique en phase vapeur activé par un plasma micro-ondes comprend une enceinte métallique 10, par exemple en laiton, ayant une enveloppe de forme générale rectangulaire ou circulaire.

L'enceinte 10 comprend un tube cylindrique interne 12, centré par rapport à l'enceinte 10 et dont la paroi est constituée d'un matériau à faibles pertes diélectriques, comme le quartz.

Le tube 12 possède à chacune de ses extrémités 14 et 15 un orifice circulaire.

La partie supérieure de l'enceinte 10 comporte une ouverture circulaire 16, centrée par rapport à l'enceinte 10, de diamètre sensiblement égal à celui de l'orifice 14 du tube 12. L'ouverture circulaire 16 est bouchée complètement par un couvercle circulaire métallique 17, en acier inoxydable par exemple. Le couvercle 17 est percé en son centre d'un orifice permettant le passage d'un tube 18 dont l'extrémité de forme géométrique particulière (par exemple cylindrique, hémisphérique ou tronconique) débouche dans le tube 12.

L'ouverture circulaire 15 de la partie inférieure du tube 12 communique avec l'extérieur par l'intermédiaire d'une autre ouverture cylindrique 29 de diamètre sensiblement égal à celui de l'ouverture 15 et réalisée dans le couvercle d'une boîte 30 en métal, en acier inoxydable par exemple, sur laquelle repose le tube 12.

L'appareil comprend encore un générateur de micro-ondes 20 émettant à une fréquence de l'ordre de 2,45 gigahertz et à une puissance de 1,2 kilowatts.

Un guide d'ondes 21 amène les micro-ondes au tube 12 selon un couplage non-résonant dans lequel le tube 12 ne dissipe pas sous forme de rayonnement électromagnétique l'énergie hyperfréquence qui lui est communiquée en présence de gaz dans ledit tube 12. L'énergie électromagnétique se propage dans ce guide dans la direction longitudinale du guide 21 (flèche 19), le champ électrique E étant orienté perpendiculairement à la direction 19.

Dans la partie initiale du guide d'ondes 21 est prévu un coupleur bidirectionnel 25. En sa partie intermédiaire de section rectangulaire 23, le guide d'ondes comporte une pluralité de vis de réglage pénétrantes 26 permettant d'adapter l'impédance du réacteur en vue d'obtenir un bon rendement de la transmission hyperfréquence, en direction du tube 12. La partie terminale 24 du guide d'ondes est progressivement amincie selon la direction parallèle au champ E et élargie selon la direction perpendiculaire au champ E jusqu'à atteindre une section droite rectangulaire plate sensiblement égale à la largeur de l'enceinte 10.

L'enceinte 10 en sa partie intermédiaire est subdivisée en deux demi-enceintes 11 et 13 séparées l'une de l'autre par un espace (ou entrefer) de section droite rectangulaire égale à celle de la partie terminale 24 du guide d'ondes. L'espace (ou entrefer) ainsi ménagé permet le couplage non-résonnant du guide d'ondes au tube 12.

Du côté diamétralement opposé à l'amenée des micro-ondes 21, il est prévu un couplage non-résonnant avec le tube. Le couplage non-résonnant est établi par un court-circuit 27 du genre piston, qui comprend une section droite rectangulaire plate sensiblement égale à celle de la partie terminale du guide d'ondes 24. La position du piston 27 est ajustée pour définir un champ électrique hyperfréquence désiré dans le tube 12.

A l'intérieur de l'enceinte 10, il est prévu un second court-circuit hyperfréquence 28 couplé au tube 12. Ce second court-circuit 28 est composé d'une plaque annulaire également du type piston. Le plasma prend naissance dans le tube 12 et il peut être plus ou moins confiné par réglage en hauteur de la plaque annulaire 28.

La boîte 30 est de forme générale circulaire et renferme le porte-échantillons 31 supportant la pièce à revêtir pouvant être mise en rotation (non montrée mais dont la position est désignée en 32) qui est placé concentriquement au tube 12. Ce porte-échantillons 31 est mobile en translation verticale, ce qui lui permet de porter la pièce 32 hors ou dans le plasma se produisant dans le tube 12.

Le tube 12 et la boîte 30 sont mis sous vide par des moyens de pompage primaire 33 (pompes de type ROOTS ayant un débit de l'ordre de 125 mètres cubes par heure par exemple) auxquels est associée une jauge de pression 34 qui possède une entrée reliée à la boîte 30 et une sortie raccordée à un contrôleur de pression 35. En réponse à la pression mesurée par la jauge 34, le contrôleur de pression 35 actionne un moteur commandant l'ouverture ou la fermeture d'une vanne 36 reliée aux moyens de pompage primaire 33 en vue de contrôler la pression dans l'enceinte.

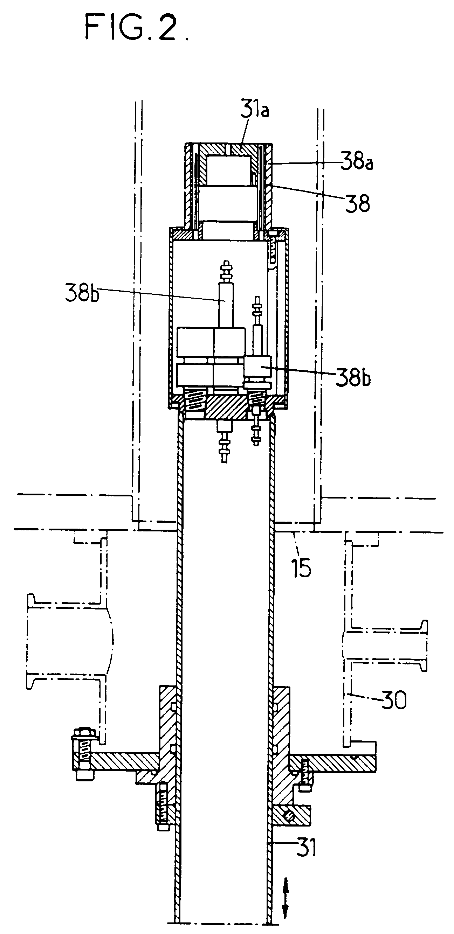

En se référant maintenant conjointement aux figures 1 et 2, pour des décapages de surface avant dépôt, l'appareil selon l'invention comprend des moyens générateurs de tension continue 37 propres à établir une polarisation continue entre les moyens d'arrivée du flux gazeux 18 et la partie métallique 31a, en cuivre par exemple, du porte-échantillons 31. Parfois il y a lieu également de chauffer l'échantillon au cours de ce décapage et/ou pendant la réalisation du dépôt proprement dit. A cette fin, l'appareil comprend en outre des moyens de chauffage indépendants 38 constitués sous forme de bobinage d'un fil résistant disposé à l'intérieur d'une coque en alumine 38a. Le système de chauffage est régulé par l'intermédiaire d'un boîtier extérieur 39 contrôlé par une sonde placée au niveau de l'échantillon 32.

Les liaisons établies respectivement entre les boîtiers de contrôle en tension 37 et en température 39 et les éléments polarisants 31a et chauffants 38 sont assurées par des passages 38b étanches.

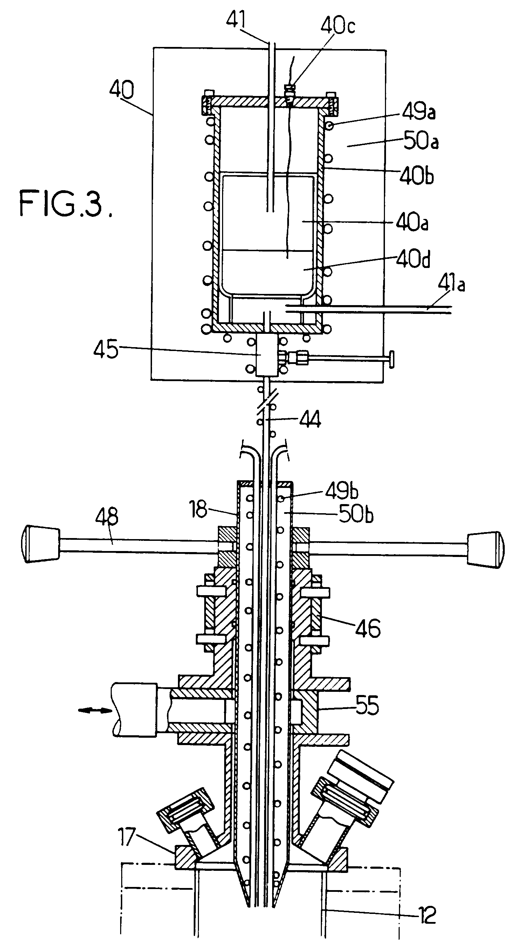

En se référant maintenant aux figures 1 et 3, l'appareil selon l'invention comprend des moyens permettant l'arrivée de gaz par l'intermédiaire du tube 18 jusque dans le tube 12. Le système d'introduction des précurseurs des éléments constitutifs du dépôt envisagé est composé de deux zones principales ayant pour fonction respective :
- le passage du précurseur de son état initial à l'état gazeux ;
- et le transport du précurseur à l'état gazeux jusque dans l'enceinte de réaction 12.

Les précurseurs des éléments constitutifs du dépôt peuvent être des solides, des liquides ou des gaz. Dans les deux premiers cas, les précurseurs sont placés dans des enceintes 40 où ils sont transformés en leur forme gazeuse par les effets de la température et/ou de la pression. Ces enceintes 40 comprennent des éléments de chauffage 49a et un calorifugeage 50a et sont reliées en amont par des tubes conventionnels souples ou rigides 41 à des bouteilles 42 qui peuvent contenir soit des gaz réactifs, soit des gaz neutres. Des moyens de contrôle 43, tels que des débitmètres et des contrôleurs de débits, permettent de contrôler et de réguler le débit du flux gazeux dans les tubes. Les gaz vecteurs traversent les précurseurs (solide, liquide ou gazeux) et débouchent en aval des enceintes, en étant chargés de précurseurs gazeux, dans des tubes 44 adaptés au transport du mélange gazeux. Ces tubes 44 sont des tubes conventionnels chauffés 49b et calorifugés 50b. En outre, les tubes 44 ont été équipés de vannes d'arrêt 45, chauffées 49a et calorifugées 50a permettant d'isoler le précurseur. Le précurseur peut donc être à volonté soit remis à l'air soit maintenu sous atmosphère de gaz vecteur selon les risques de détérioration.

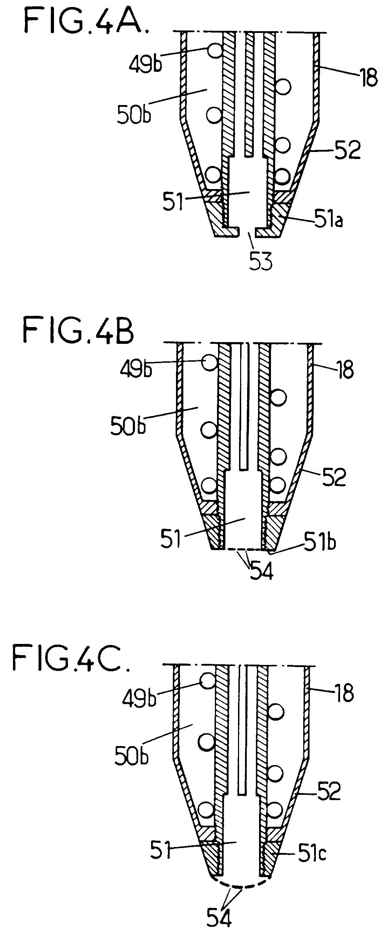

En se référant aux figures 4A à 4C, les différents précurseurs, tous pris sous leur forme gazeuse, peuvent éventuellement être mélangés dans une chambre de mélange 51 prévue à cet effet dans la buse d'injection 52, de forme externe tronconique qui termine le tube 18 à son débouché dans le tube 12.

La buse 52 est munie d'un orifice unique 53 (fig. 4A) ou bien d'orifices multiples 54 (fig. 4B et 4C), de dimension inférieure à la section du tube 18.

La forme géométrique originale de la partie terminale du tube 18, à savoir un cône tronqué duquel débouchent -par un orifice unique 51a ou par plusieurs orifices (définis alors par exemple par une grille ou un treillis 51b (fig. 4B) ou une plaque en forme de calotte sphérique perforée 51c (fig. 4C))- les gaz vecteurs chargés des précurseurs gazeux constitutifs du dépôt, permet d'assurer l'ionisation maximale du jet de gaz sous forme d'une colonne s'appuyant sur le porte-échantillons. La largeur de ladite colonne est fonction de la forme géométrique choisie pour la buse d'injection (elle augmente quand on passe d'un orifice unique à un orifice multiple).

A titre d'exemple, on va maintenant décrire, en se référant aux fig. 1 et 3, la mise en oeuvre de l'appareil de l'invention dans le cas du dépôt d'un oxyde de zirconium. Le précurseur métallique se présente sous forme de poudre 40d et est contenu dans un creuset filtrant en quartz 40a lui-même reçu dans une enceinte en acier inoxydable 40b. Celle-ci est placée dans une enceinte 40 qui permet de chauffer la poudre grâce à un système de colliers chauffants 49a. La régulation en température de l'enceinte 40 est réalisée par l'intermédiaire d'un boîtier extérieur contrôlé par une sonde 40c placée dans la poudre. L'oxygène, gaz réactif, est quant à lui transporté par l'intermédiaire du tube conventionnel 41a.

Par l'intermédiaire du tube 41, de l'argon, gaz neutre, est introduit dans l'enceinte 40a. La poudre chauffée sous pression réduite passe sous forme gazeuse. Le gaz neutre se charge en précurseur gazeux, traverse la poudre et par l'intermédiaire du tube 44 est introduit dans l'enceinte 12 avec l'oxygène. Le tube 44 est chauffé par un système de cordons chauffants 49b bobinés et calorifugés 50b, le tout étant maintenu dans le tube 18. Des poignées 48 fixées sur le tube 18 permettent une translation verticale de ce tube. En position haute la vanne d'arrêt 55 peut être fermée afin d'isoler le précurseur. Le couvercle 17 et tous les éléments qui lui sont rattachés peuvent être translatés verticalement grâce au système de levage 46.

Le rapport des débits oxygène/argon peut varier entre 2 et 10. Les essais ont été conduits avec des pressions dans l'enceinte allant de 100 à 1000 Pa. L'ajustement du couplage est effectué par positionnement du piston 27 et des vis d'adaptation 26. On a pu obtenir, avec une vitesse de dépôt moyenne de 100 µm/h, une couche de zircone monoclinique de structure colonnaire sur un substrat en alliage MCrAlY.

De façon générale, l'appareil de l'invention permet de réaliser tout type de revêtements céramiques dans la mesure où les précurseurs existent ou peuvent être produits et sont transportables sous forme gazeuse. Les composants de ces céramiques peuvent être des oxydes purs (SiO₂, Al₂O₃,...), des combinaisons d'oxydes (ZrO₂ - Y₂O₃, SiO₂ - GeO₂,...) des métalloïdes (C, B, Si,...), des combinaisons de métalloïdes (SiC, B₄C, BN,...), ou encore des combinaisons métalloïde/métal (TiC, TiB₂, AlN,...).

L'appareil peut trouver une application pour la réalisation de barrières thermiques en zircone partiellement stabilisée avec de l'yttrine. Des débouchés sont envisageables dans le domaine des turbines (fabrication d'aubes fixes et mobiles).

D'autres applications pourraient concerner notamment:
- les isolants pour la microélectronique,
- les électrolytes sous forme solide pour les cellules de combustible à haute température,
- les miroirs pour l'optique laser,
- les composites alumine/zircone (dépôt de matrice sur fibres, torons, tissus).

De façon générale l'industrie des traitements et revêtements de surface peut utiliser cet appareil. On peut citer, par exemple, l'application à la fabrication des outils de coupe.

Comme il va de soi et comme il résulte d'ailleurs déjà de ce qui précède, l'invention ne se limite nullement à ceux de ses modes d'application et de réalisation qui ont été plus particulièrement envisagés ; elle en embrasse, au contraire, toutes les variantes.

## Revendications

1. Appareil de dépôt chimique en phase vapeur activé par un plasma, comprenant, disposés les une à la suite des autres :
- plusieurs moyens (40) de transformation d'état de précurseurs respectifs de plusieurs matériaux de dépôt pour les faire passer chacun d'un état initial à l'état gazeux,
- plusieurs moyens (40b, 41) pour charger des gaz vecteurs en précurseurs gazeux respectifs, chaque gaz vecteur chargé en précurseur constituant un mélange gazeux prédéterminé,
- plusieurs moyens de transfert desdits mélanges gazeux prédéterminés vers un réacteur à plasma à excitation par micro-ondes comportant une enceinte de réaction (10), un générateur de micro-ondes (20), au moins un guide d'ondes (21) interposé entre ledit générateur et l'enceinte assurant un couplage non résonant, et
- des moyens d'injection (51-54) desdits mélanges gazeux prédéterminés dans l'enceinte de réaction,
caractérisé en ce que les moyens de transfert (44) des mélanges gazeux prédéterminés respectifs sont indépendants les uns des autres et en ce que les moyens d'injection comportent une buse (52) à profil externe tronconique dans laquelle débouchent les susdits moyens de transfert indépendants et qui est pourvue d'au moins un orifice d'injection (53, 54), l'extrémité de ladite buse étant conformée en fonction de la configuration du jet de gaz ionisé désirée, cette buse étant équipée de moyens (49b, 50b) de chauffage et de calorifugeage du mélange gazeux prédéterminé.

2. Appareil de dépôt selon la revendication 1, le précurseur étant à l'état solide ou liquide, caractérisé en ce que les moyens de transformation d'état du précurseur comprennent au moins une chambre (40) équipée de moyens de réglage de température et/ou de pression pour la transformation en phase gazeuse de ce précurseur.

3. Appareil de dépôt selon la revendication 1 ou 2, le précurseur étant à l'état solide, caractérisé en ce que les moyens pour charger un gaz vecteur en précurseur gazeux sont agencés pour que le gaz vecteur traverse le précurseur pulvérulent (40d).

4. Appareil de dépôt selon l'une quelconque des revendications 1 à 3, caractérisé en ce que le gaz vecteur est neutre vis-à-vis du précurseur.

5. Appareil de dépôt selon l'une quelconque des revendications 1 à 3, caractérisé en ce que le gaz de transport est réactif chimiquement avec le précurseur.

6. Appareil de dépôt selon l'une quelconque des revendications 1 à 5, caractérisé en ce que les moyens de transfert du mélange gazeux prédéterminé comprenant au moins un tube de transfert (44) chauffé et/ou calorifugé et au moins une vanne d'arrêt (45) chauffée et/ou calorifugée.

7. Appareil de dépôt selon la revendication 5, dans lequel plusieurs mélanges gazeux prédéterminés différents sont injectés dans l'enceinte, caractérisé en ce que la buse (52) comprend une chambre de mélange (51) dans laquelle débouchent tous les tubes de transfert respectifs (44) des mélanges gazeux prédéterminés différents et disposée en amont de l'orifice d'injection (53, 54).

8. Appareil de dépôt selon l'une quelconque des revendications 1 à 7, caractérisé en ce que la buse (52) est pourvue d'un unique orifice de sortie (53).

9. Appareil de dépôt selon l'une quelconque des revendications 1 à 7, caractérisé en ce que la buse (52) est pourvue d'une multiplicité d'orifices de sortie (54) définis par des moyens de subdivision.

10. Appareil de dépôt selon la revendication 9, caractérisé en ce que les moyens de subdivision comprennent un grillage ou treillis.

11. Appareil de dépôt selon la revendication 9, caractérisé en ce que les moyens de subdivision comprennent une plaque perforée.

## Patentansprüche

1. Vorrichtung zur plasmaaktivierten chemischen Gasphasenabscheidung, umfassend eines nach dem anderen angeordnet:
- mehrere Zustandsüberführmittel (40) zum Überführen des Zustandes jeweiliger Vorläuferstoffe mehrerer Abscheidungsamaterialien, um sie jeweils von einem Anfangszustand in den gasförmigen Zustand zu überführen,
- mehrere Belademittel (40b, 41) zum Beladen von Trägergasen mit jeweiligen gasförmigen Vorläuferstoffen, wobei jedes vorläuferstoff-beladene Trägergas eine vorbestimmte gasförmige Mischung bildet,
- mehrere Zuführmittel zum Zuführen der vorbestimmten gasförmigen Mischungen in Richtung eines mit Mikrowellen angeregten Plasmareaktors, der ein Reaktionsgefäß (10), einen Mikrowellengenerator (20) und wenigstens einen Wellenleiter (21) umfaßt, wobei der wenigstens eine Wellenleiter (21) zwischen dem Generator und dem Gefäß eingefügt ist, unter Gewährleistung einer nicht-resonanten Kopplung, und
- Injektionsmittel (51-54) zur Injektion der vorbestimmten gasförmigen Mischungen in das Reaktionsgefäß,
dadurch gekennzeichnet, daß die Zuführmittel (44) zum Zuführen der jeweiligen vorbestimmten gasförmigen Mischungen unabhängig voneinander sind und daß die Injektionsmittel eine Düse (52) mit kegelstumpfförmigem äußerem Profil umfassen, in welche die unabhängigen Zuführmittel münden und welche mit wenigstens einer Injektionsöffnung (53, 54) ausgestattet ist, wobei das Ende der Düse in Abhängigkeit von der gewünschten Gestalt des ionisierten Gasstrahls ausgebildet ist, und wobei diese Düse mit Mitteln (49b, 50b) zum Heizen und zum Wärmedämmen der vorbestimmten gasförmigen Mischung ausgestattet ist.

2. Vorrichtung zur Abscheidung nach Anspruch 1, wobei der Vorläuferstoff in festem oder flüssigem Zustand ist, dadurch gekennzeichnet, daß die Überführmittel zum Überführen des Vorläuferstoffzustands wenigstens eine Kammer (40) umfassen, die für das Überführen dieses Vorläuferstoffes in die gasförmige Phase mit Mitteln zum Einstellen der Temperatur und/oder des Druckes ausgestattet ist.

3. Vorrichtung zur Abscheidung nach Anspruch 1 oder 2, wobei der Vorläuferstoff im festen Zustand ist, dadurch gekennzeichnet, daß die Belademittel zum Beladen eines Trägergases mit einem gasförmigen Vorläuferstoff so gestaltet sind, daß das Trägergas den feinpulverigen Vorläuferstoff (40d) durchströmt.

4. Vorrichtung zur Abscheidung nach einem der Ansprüche 1 bis 3, dadurch gekennzeichnet, daß das Trägergas neutral gegenüber dem Vorläuferstoff ist.

5. Vorrichtung zur Abscheidung nach einem der Ansprüche 1 bis 3, dadurch gekennzeichnet, daß das Transportgas chemisch reaktiv mit dem Vorläuferstoff ist.

6. Vorrichtung zur Abscheidung nach einem der Ansprüche 1 bis 5, dadurch gekennzeichnet, daß die Zuführmittel zum Zuführen der vorbestimmten gasförmigen Mischung wenigstens ein geheiztes und/oder wärmegedämmtes Zuführrohr (44) zum Zuführen und wenigstens ein geheiztes und/oder wärmegedämmtes Sperrventil (45) umfassen.

7. Vorrichtung zur Abscheidung nach Anspruch 5, bei der mehrere verschiedene vorbestimmte gasförmige Mischungen in das Gefäß injiziert werden, dadurch gekennzeichnet, daß die Düse (52) eine Mischkammer (51) umfaßt, in welche alle jeweiligen Zuführrohre (44) verschiedener vorbestimmter gasförmiger Mischungen münden und welche stromaufwärts der Injektionsöffnung (53, 54) angeordnet ist.

8. Vorrichtung zur Abscheidung nach einem der Ansprüche 1 bis 7, dadurch gekennzeichnet, daß die Düse (52) mit einer einzigen Austrittsöffnung (53) ausgestattet ist.

9. Vorrichtung zur Abscheidung nach einem der Ansprüche 1 bis 7, dadurch gekennzeichnet, daß die Düse (52) mit einer Mehrzahl von Austrittsöffnungen (54) ausgestattet ist, die durch Unterteilungsmittel gebildet sind.

10. Vorrichtung zur Abscheidung nach Anspruch 9, dadurch gekennzeichnet, daß die Unterteilungsmittel ein Gitter oder ein Geflecht umfassen.

11. Vorrichtung zur Abscheidung nach Anspruch 9, dadurch gekennzeichnet, daß die Unterteilungsmittel eine perforierte Platte umfassen.

## Claims

1. Apparatus for plasma activated chemical vapor deposition, the apparatus comprising disposed one after another:
a plurality of transformation means (40) for transforming the state of respective precursors of a plurality of deposition materials to cause each of them to pass from an initial state to the gaseous state;
a plurality of charging means (40b, 41) for charging vector gases with respective gaseous precursors, each precursor-charged vector gas constituting a predetermined gaseous mixture;
a plurality of transfer means for transferring said predetermined gaseous mixtures to a plasma reactor having microwave excitation comprising a reaction enclosure (10), a microwave generator (20), and at least one waveguide (21) interposed between said generator and the enclosure and providing non-resonant coupling; and
injection means (51-54) for injecting said predetermined gaseous mixtures into the reaction enclosure;
characterized in that the transfer means (44) for transferring the respective predetermined gaseous mixtures are independent of one another and in that the injection means include a nozzle (52) of frustoconical external profile into which the above-mentioned independent transfer means open out and which is provided with at least one injection orifice (53, 54), the end of said nozzle being shaped as a function of the desired configuration for the jet of ionized gas, said nozzle being fitted with means (49b, 50b) for heating and for thermally insulating the predetermined gaseous mixture.

2. Deposition apparatus according to claim 1, the precursor being in the solid or liquid state, characterized in that the transformation means for transforming the state of the precursor comprise at least one chamber (40) fitted with means for adjusting temperature and/or pressure to transform the precursor into the gaseous phase.

3. Deposition apparatus according to claim 1 or 2, the precursor being in the solid state, characterized in that the charging means for charging a vector gas with gaseous precursor are organized so that the vector gas passes through the precursor in powder form (40d).

4. Deposition apparatus according to any one of claims 1 to 3, characterized in that the vector gas is inert relative to the precursor.

5. Deposition apparatus according to any one of claims 1 to 3, characterized in that the transport gas is chemically reactive with the precursor.

6. Deposition apparatus according to any one of claims 1 to 5, characterized in that the transfer means for transferring the predetermined gaseous mixture include at least one transfer tube (44) that is heated and/or thermally insulated, and at least one stop valve (45) that is heated and/or thermally insulated.

7. Deposition apparatus according to claim 5, in which a plurality of different predetermined gaseous mixtures are injected into the enclosure, characterized in that the nozzle (52) includes a mixing chamber (51) into which there open out all of the respective transfer tubes (44) for the different predetermined gaseous mixtures, which chamber is located upstream from the injection orifice (53, 54).

8. Deposition apparatus according to any one of claims 1 to 7, characterized in that the nozzle (52) is provided with a single outlet orifice (53).

9. Deposition apparatus according to any one of claims 1 to 7, characterized in that the nozzle (52) is provided with a multiplicity of outlet orifices (54) defined by subdivision means.

10. Deposition apparatus according to claim 9, characterized in that the subdivision means comprise a grid or trellis.

11. Deposition apparatus according to claim 9, characterized in that subdivision means comprise a perforated plate.
